# EUROPEAN PATENT APPLICATION

(11) **EP 4 730 936 A1**
(43) Date of publication of application: **22.04.2026**
(21) Application number: 24899396.6
(22) Date of filing: 13.09.2024
(51) Int. Cl.: H05K 7/20

(54) **TERMINAL DEVICE**

(30) Priority: 08.12.2023 CN 202311687758
(71) Applicant: Huawei Technologies Co., Ltd., Shenzhen, Guangdong 518129 (CN)
(72) Inventor: HUANG, Bo, Shenzhen, Guangdong 518129 (CN); ZHA, Peng, Shenzhen, Guangdong 518129 (CN); ZHANG, Yiqin, Shenzhen, Guangdong 518129 (CN); ZOU, Mengruo, Shenzhen, Guangdong 518129 (CN)
(74) Representative: Isarpatent
(86) International application number: PCT/CN2024/118729
(87) International publication number: WO 2025/118750

(57) **Abstract**

A terminal device is provided, including a housing, a circuit board, a heat generation component, an air duct, a heat dissipation member, and a fan apparatus. The housing is provided with an air inlet hole and an air outlet hole. The circuit board is disposed in the housing. The heat generation component is disposed on the circuit board. The air duct is disposed between the housing and the circuit board. The air duct includes an air inlet and an air outlet. The air inlet communicates with the air inlet hole. The air outlet communicates with the air outlet hole. The heat dissipation member is disposed at a position that is in the air duct and that is close to the air outlet, to receive heat conducted by the heat generation component. The fan apparatus is disposed at a position that is in the air duct and that is close to the air inlet, to guide an airflow to the heat dissipation member, so that heat of the heat dissipation member is dissipated to an exterior of the housing sequentially through the air outlet and the air outlet hole via the airflow. In this application, a heat dissipation system including the heat dissipation member, the fan apparatus, the air duct, and the like is disposed inside the terminal device. This can implement active heat dissipation to achieve efficient cooling of the heat generation component, thereby enabling the terminal device to achieve good performance during running in a high-load scenario.

## Description

The present invention claims priority to Chinese Patent Application No. 202311687758.2, filed with the China National Intellectual Property Administration on December 8, 2023 and entitled "TERMINAL DEVICE", which is incorporated herein by reference in its entirety.

### TECHNICAL FIELD

This application relates to the field of electronic product technologies, and specifically, to a terminal device.

### BACKGROUND

With the rapid development of smartphone chip technologies and higher performance requirements of third-party applications, smartphones bear heavier loads and face increasingly severe heat generation problems. Current technical solutions are mainly based on passive heat dissipation, that is, heat is conducted to a surface of a smartphone mainly through thermal conduction between smartphone components, and then natural heat exchange is performed with air through thermal convection, resulting in low heat dissipation efficiency.

### SUMMARY

In view of this, this application provides a terminal device, to improve heat dissipation efficiency of a main heat generation component in the terminal device through active heat dissipation.

An embodiment of this application provides a terminal device, including a housing, a circuit board, a heat generation component, an air duct, a heat dissipation member, and a fan apparatus. The housing is provided with an air inlet hole and an air outlet hole. The circuit board is disposed in the housing. The heat generation component is disposed on the circuit board. The air duct is disposed between the housing and the circuit board. The air duct includes an air inlet and an air outlet. The air inlet communicates with the air inlet hole. The air outlet communicates with the air outlet hole. The heat dissipation member is disposed at a position that is in the air duct and that is close to the air outlet, to receive heat conducted by the heat generation component. The fan apparatus is disposed at a position that is in the air duct and that is close to the air inlet, to guide an airflow to the heat dissipation member, so that heat of the heat dissipation member is dissipated to an exterior of the housing sequentially through the air outlet and the air outlet hole via the airflow.

According to the terminal device provided in this embodiment of this application, a heat dissipation system including the heat dissipation member, the fan apparatus, the air duct, and the like is disposed inside the terminal device. This can implement active heat dissipation to achieve efficient cooling of the heat generation component, thereby enabling the terminal device to achieve good performance during running in a high-load scenario and improving use experience of a user.

In a possible design, in a thickness direction of the terminal device, at least a part of a projection of the heat generation component coincides with a projection of the heat dissipation member. Making at least the part of the projection of the heat generation component in the thickness direction of the terminal device coincide with the projection of the heat dissipation member can shorten a heat dissipation path between the heat generation component and the heat dissipation member. As a result, most heat of the heat generation component can be quickly conducted to the heat dissipation member, and heat exchange can be performed through the heat dissipation member, thereby implementing quick and efficient cooling.

In a possible design, the terminal device further includes a first thermally conductive medium made of a flexible material, the first thermally conductive medium is disposed between the circuit board and the air duct, and heat of the heat generation component is conducted to the heat dissipation member sequentially through the first thermally conductive medium and a side wall of the air duct. Both the circuit board and the air duct are made of hard materials. Therefore, when the circuit board and the air duct are directly connected to each other, it is difficult to ensure a tight connection between the circuit board and the air duct, and a gap is likely to form between the circuit board and the air duct. Consequently, heat cannot be effectively conducted to the heat dissipation member in the air duct. To address this, in this embodiment, the first thermally conductive medium made of the flexible material is used, and the first thermally conductive medium may be fully filled between the circuit board and the air duct through flexible deformation of the first thermally conductive medium. This can ensure that there is no gap in a heat conduction path between the circuit board and the air duct, thereby improving heat conduction efficiency and improving heat dissipation efficiency.

In a possible design, the first thermally conductive medium is made of thermally conductive gel or thermal grease. Due to excellent thermal conduction capabilities and specific degrees of flexibility, these materials can be fully filled between the circuit board and the air duct, thereby eliminating a gap in the heat conduction path and improving the heat dissipation efficiency.

In a possible design, the terminal device further includes an electromagnetic shielding member, the electromagnetic shielding member is disposed between the first thermally conductive medium and the circuit board, the electromagnetic shielding member is provided with an accommodation groove, and the accommodation groove is configured to accommodate a component on the circuit board. At least a part of heat of the heat generation component is conducted to the heat dissipation member sequentially through the electromagnetic shielding member, the first thermally conductive medium, and the side wall of the air duct. The electromagnetic shielding member may be a member made of metal, such as copper or aluminum, and has an electromagnetic shielding function. A component that generates electromagnetic interference or a component that is affected by electromagnetic interference may be covered in the accommodation groove, to isolate the electromagnetic interference through the accommodation groove. In addition, because the electromagnetic shielding member is a member made of metal, that is, both the electromagnetic shielding member and the air duct are rigid members, if the electromagnetic shielding member and the air duct are directly connected to each other, a gap is likely to form between the electromagnetic shielding member and the air duct. Due to the gap, heat cannot be effectively conducted to the heat dissipation member, which reduces the heat dissipation efficiency. To address this, in this embodiment, the first thermally conductive medium may be filled between the electromagnetic shielding member and the air duct. The first thermally conductive medium may be fully filled between the electromagnetic shielding member and the air duct by using flexibility of the first thermally conductive medium, to eliminate a gap. In addition, the electromagnetic shielding member made of metal exhibits an excellent thermal conduction property, so that heat generated by the heat generation component can be efficiently conducted to the heat dissipation member sequentially through the electromagnetic shielding member, the first thermally conductive medium, and the side wall of the air duct. The side wall of the air duct is a side wall configured to connect to the heat dissipation member.

In a possible design, the electromagnetic shielding member includes a body and a cover plate, the body is disposed on the circuit board, the accommodation groove is a through groove, and the through groove runs through the body in a thickness direction of the terminal device; and the cover plate is fitted to a side that is of the body and that is away from the circuit board, to seal the through groove, and the cover plate is connected to the air duct through the first thermally conductive medium. After the body is mounted onto the circuit board, a second thermally conductive medium such as thermally conductive gel or thermal grease may be injected into the through groove, to implement heat conduction for a component in the through groove. In this embodiment, the cover plate may be fitted to the body to seal the through groove. This facilitates injection of thermally conductive gel with a higher thermal conductivity into the through groove, to improve a thermal conduction capability and consequently improve heat dissipation efficiency of the heat generation component.

In a possible design, the electromagnetic shielding member is made of thermally conductive metal. Therefore, the electromagnetic shielding function can be achieved, and heat exchange efficiency can be improved.

In a possible design, the terminal device further includes a second thermally conductive medium made of a flexible material, and the second thermally conductive medium is filled between the component in the accommodation groove and an inner wall of the accommodation groove. The second thermally conductive medium may be fully filled between the heat generation component and the inner wall of the accommodation groove by using flexibility of the second thermally conductive medium, to eliminate a gap. As a result, the heat generated by the heat generation component in the accommodation groove can be conducted to the heat dissipation member sequentially through the second thermally conductive medium, the electromagnetic shielding member, the first thermally conductive medium, and a wall plate of the air duct, thereby improving the heat dissipation efficiency.

In a possible design, the second thermally conductive medium is made of thermally conductive gel or thermal grease. Due to excellent thermal conduction capabilities and specific degrees of flexibility, these materials can be fully filled between the circuit board and the air duct, thereby eliminating a gap in the heat conduction path and improving the heat dissipation efficiency.

In a possible design, in the thickness direction of the terminal device, at least a part of projections of the first thermally conductive medium and the electromagnetic shielding member coincides with projections of the heat dissipation member and the fan apparatus. In other words, the projections of the first thermally conductive medium and the electromagnetic shielding member in the thickness direction of the terminal device may cover both the heat dissipation member and the fan apparatus. As a result, most heat generated by the heat generation component can be conducted to the relatively closer heat dissipation member sequentially through the electromagnetic shielding member and the first thermally conductive medium. In addition, at least a part of heat generated by the heat generation component can be conducted to the relatively farther fan apparatus through the electromagnetic shielding member and the first thermally conductive medium, so that the heat can be conducted to a structure such as a blade of the fan apparatus and heat exchange can be performed with air through the fan apparatus. This can further expand, through the fan apparatus, a heat dissipation area in contact with the air, thereby improving the heat dissipation efficiency.

In a possible design, the air duct includes an air inlet duct and an air outlet duct, the air inlet duct communicates with the air outlet duct, the fan apparatus is disposed in the air inlet duct, and the heat dissipation member is disposed in the air outlet duct. The fan apparatus in the air inlet duct is close to the air inlet of the air duct, so that air outside the terminal device can be quickly drawn into the air duct through the air inlet and can be blown to the heat dissipation member by the fan apparatus, for heat exchange with the heat dissipation member. The heat dissipation member is disposed in the air outlet duct and is close to the air outlet of the air duct, so that high-temperature air after the heat exchange with the heat dissipation member can be quickly output to an exterior of the terminal device from the air outlet. In this way, efficient heat dissipation can be implemented.

In a possible design, the air duct is provided with a thermal equalization portion, and the thermal equalization portion is disposed on at least a part of a portion that is of the air duct and that is close to the air outlet. The thermal equalization portion has an excellent thermal conduction capability and a large heat dissipation area. After air with a low temperature input by the fan apparatus exchanges heat with the heat dissipation member, one part of a high-temperature airflow after the heat exchange may be output to the exterior of the terminal device from the air outlet and the air outlet hole, and the other part of the hot airflow may be in contact with the thermal equalization portion for heat exchange. The thermal equalization portion may diffuse heat into nearby air, and heat exchange may be further performed with air outside the terminal device through the housing. In this way, heat in the housing is dissipated to the exterior of the terminal device.

In a possible design, the thermal equalization portion is a graphite layer. The graphite layer has an excellent thermal conduction capability, and can improve efficiency of heat exchange with a hot airflow. In addition, the graphite layer may be coated on an outer wall of the air duct and a part of an inner wall that is of the air duct and that is close to the air outlet, facilitating processing on the air duct. The graphite layer may be flexibly disposed based on an actual heat dissipation position. Besides, the graphite layer may be of a small thickness, which helps save space.

In a possible design, the air duct is connected to the housing through adhesive bonding or through a connection member, thereby facilitating connection between the air duct and the housing.

In a possible design, the air duct is integrally formed with the housing. In other words, a structure of the air duct is integrally formed during processing of the housing. This can improve structural strength and reliability of the air duct and the housing, and facilitates production and manufacturing.

In a possible design, the heat generation component is disposed on a side that is of the circuit board and that is away from the air duct.

In a possible design, the heat dissipation member includes a plurality of metal fins. The plurality of fins may be spaced apart, thereby significantly expanding an area in contact with air. This can implement efficient heat exchange, and achieve quick and effective heat dissipation.

In a possible design, the housing includes a battery cover and a camera decoration member, the camera decoration member is disposed on the battery cover, the camera decoration member protrudes from an outer wall of the battery cover, the camera decoration member has accommodation space inside, and at least a part of the air duct is disposed in the accommodation space. The camera decoration member protrudes from the outer wall of the battery cover, and has the accommodation space inside, where the accommodation space may be configured to accommodate a camera module, and at least the part of the air duct may also be disposed in the accommodation space inside the camera decoration member. The camera decoration member protrudes from a surface of the battery cover, that is, configuration of the camera decoration member limits an overall thickness of the terminal device. At least a part of the air duct may be disposed between the battery cover and the circuit board, and at least a part of the air duct may be accommodated in the accommodation space inside the camera decoration member. In this way, the camera decoration member can incorporate a part of a thickness of the air duct, thereby eliminating a need for the air duct to occupy additional Z-direction space of the entire terminal device. This facilitates a thinning design of the terminal device.

In a possible design, in a first direction, the camera decoration member has a side wall; the side wall is provided with the air inlet hole and the air outlet hole; and the first direction is perpendicular to the thickness direction of the terminal device. The air inlet hole and the air outlet hole may be provided at appropriate positions on the side wall, and the air inlet and the air outlet may be provided at positions on a part that is of the air duct and that is in the camera decoration member, so that the air inlet and the air outlet are close to, or are aligned with and communicate with the air inlet hole and the air outlet hole on the camera decoration member respectively. This can ensure air intake and air exhaust efficiency, thereby helping improve the heat dissipation efficiency.

In a possible design, the heat generation component is a system on chip, a power management unit, or a UNIX file system.

It should be understood that the foregoing general descriptions and the following detailed descriptions are merely examples, and are not intended to limit this application.

### BRIEF DESCRIPTION OF DRAWINGS

To describe technical solutions in embodiments of this application more clearly, the following briefly describes the accompanying drawings for embodiments. It is clear that the accompanying drawings in the following descriptions show merely some embodiments of this application, and a person of ordinary skill in the art may derive other drawings from these accompanying drawings without creative efforts.
FIG. 1 is a diagram of a structure of a terminal device according to an embodiment of this application;
FIG. 2 is a partial sectional view of a terminal device in a side view perspective according to a first embodiment of this application;
FIG. 3 is a partial sectional view of a terminal device in a side view perspective according to a second embodiment of this application;
FIG. 4 is a partial sectional view of a terminal device in a top view perspective according to an embodiment of this application;
FIG. 5 is a partial sectional view of a terminal device in a side view perspective according to a third embodiment of this application;
FIG. 6 is a partial sectional view of a terminal device in a side view perspective according to a fourth embodiment of this application;
FIG. 7 is a partial sectional view of a terminal device in a side view perspective according to a fifth embodiment of this application; and
FIG. 8 is a partial sectional view of a terminal device in a side view perspective according to a sixth embodiment of this application.

### Reference numerals:

1: housing;
   11: battery cover;
   12: camera decoration member;
   13: air inlet hole;
   14: air outlet hole;
2: circuit board;
3: air duct;
   31: air inlet duct;
      311: air inlet;
   32: air outlet duct;
      321: air outlet;
   33: thermal equalization portion;
4: heat dissipation member;
5: fan apparatus;
6: heat generation component;
   61: double data rate synchronous dynamic random access memory;
7: first thermally conductive medium;
8: second thermally conductive medium;
9: electromagnetic shielding member;
   91: body;
   92: cover plate;
Z: thickness direction;
X: first direction.

### DESCRIPTION OF EMBODIMENTS

To better understand technical solutions of this application, the following describes embodiments of this application in detail with reference to the accompanying drawings.

It should be clear that described embodiments are merely some rather than all of embodiments of this application. All other embodiments obtained by a person of ordinary skill in the art based on embodiments of this application without creative efforts shall fall within the protection scope of this application.

Terms used in embodiments of this application are merely intended to describe specific embodiments, but are not intended to limit this application. The terms "a", "said" and "the" of singular forms used in embodiments and the appended claims of this application are also intended to include plural forms, unless otherwise specified in the context clearly.

It should be understood that the term "and/or" used in this specification describes only an association relationship between associated objects and indicates that three relationships may exist. For example, A and/or B may indicate the following three cases: Only A exists, both A and B exist, and only B exists. In addition, the character "/" in this specification generally indicates an "or" relationship between the associated objects.

In descriptions of this application, unless otherwise specified and limited, the terms "first" and "second" are merely intended for description, and shall not be understood as an indication or implication of relative importance. Unless otherwise specified or stated, the term "a plurality of" means two or more. The terms "connect", "fasten", and the like should be all understood in a broad sense. For example, "connect" may be a fixed connection, a detachable connection, an integral connection, or an electrical connection, or may be a direct connection or an indirect connection through an intermediate medium. A person of ordinary skill in the art may understand specific meanings of the foregoing terms in this application based on specific situations.

With the rapid development of smartphone chip technologies and higher performance requirements of third-party applications, smartphones bear heavier loads and face increasingly severe heat generation problems. Current technical solutions are mainly based on passive heat dissipation, that is, heat is conducted to a surface of a smartphone mainly through thermal conduction between smartphone components, and then natural heat exchange is performed with air through thermal convection. For example, a heat dissipation path of a system on chip (System-On-a-Chip, SOC) is mainly single-sided, that is, a vapor chamber (vapor chamber, VC) is used on a screen side for heat dissipation. The heat dissipation path is monolithic, and heat dissipation efficiency is low. In addition, this heat dissipation manner cannot implement efficient heat dissipation in high-load running scenarios such as gaming, image shooting, and video processing, causing a device to heat up severely and affecting running performance.

An embodiment of this application provides a terminal device. The terminal device is also referred to as a terminal, user equipment (user equipment, UE), a mobile station, a mobile terminal, or the like. The terminal device may be widely used in various scenarios, for example, D2D communication, V2X communication, machine-type communication (machine-type communication, MTC), IoT, virtual reality, augmented reality, industrial control, autonomous driving, telemedicine, smart grid, smart furniture, smart office, smart wearable, smart transportation, and smart city. For example, the terminal device may be a mobile phone, a computer, a mobile internet device (mobile internet device, MID), a wearable device, a virtual reality (virtual reality, VR) device, an augmented reality (augmented reality, AR) device, a robotic arm, a camera, a robot, a smart home device (for example, a television, an air conditioner, a robotic vacuum cleaner, a sound box, or a set-top box), a relay (relay), or customer premises equipment (customer premises equipment, CPE).

If the various terminal devices described above are located in a vehicle (for example, placed or installed in the vehicle), the terminal devices may be all considered as vehicle-mounted terminal devices. The vehicle-mounted terminal device may be a vehicle-mounted module, a vehicle-mounted assembly, a vehicle-mounted component, a vehicle-mounted chip, or an on-board unit that is built in a vehicle as one or more components or units. The vehicle may implement the method in this application through the built-in vehicle-mounted module, vehicle-mounted assembly, vehicle-mounted component, vehicle-mounted chip, or on-board unit. The vehicle-mounted terminal device may be an entire vehicle device, a vehicle-mounted module, a vehicle, an on-board unit (on-board unit, OBU), a roadside unit (roadside unit, RSU), a head unit system (or referred to as a vehicle-mounted sending unit) (telematics box, T-box), a chip, a system on chip (system on chip, SOC), or the like. The chip or the SOC may be installed in a vehicle, an OBU, an RSU, a T-box, or the like.

In embodiments of this application, an apparatus configured to implement a function of the terminal device may be the terminal device, or may be an apparatus that can support the terminal device in implementing the function, for example, a chip system or a combined component or part that can implement the function of the terminal device. The apparatus may be installed in the terminal device. A specific technology and a specific device form that are used by the terminal device are not limited in embodiments of this application.

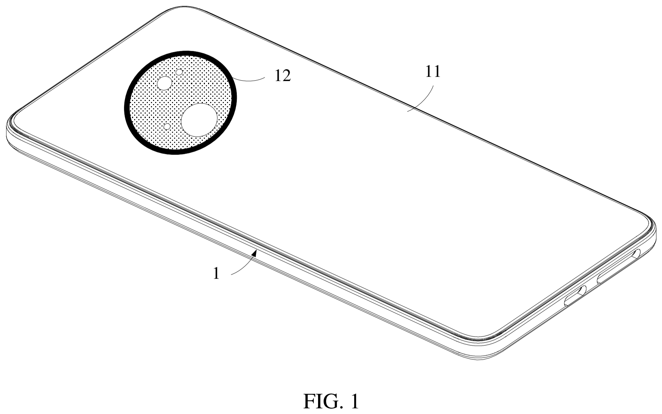

The terminal device may also be referred to as a terminal, a terminal apparatus, user equipment (user equipment, UE), a mobile station, a mobile terminal, or the like. The terminal may be widely used in various scenarios, for example, device-to-device (device-to-device, D2D) communication, vehicle-to-everything (vehicle-to-everything, V2X) communication, machine-type communication (machine-type communication, MTC), internet of things (internet of things, IoT), virtual reality, augmented reality, industrial control, autonomous driving, telemedicine, smart grid, smart furniture, smart office, smart wearable, smart transportation, and smart city. The terminal may be a mobile phone, a tablet computer, a computer with a wireless transceiver function, a wearable device, a vehicle, an uncrewed aerial vehicle, a helicopter, an airplane, a ship, a robot, a robotic arm, a smart home device, or the like. A specific technology and a specific device form that are used by the terminal are not limited in embodiments of this application. FIG. 1 is a diagram of a structure of a terminal device according to an embodiment of this application. FIG. 1 shows an example in which the terminal device is a mobile phone, and the example in which the terminal device is a mobile phone is used for description.

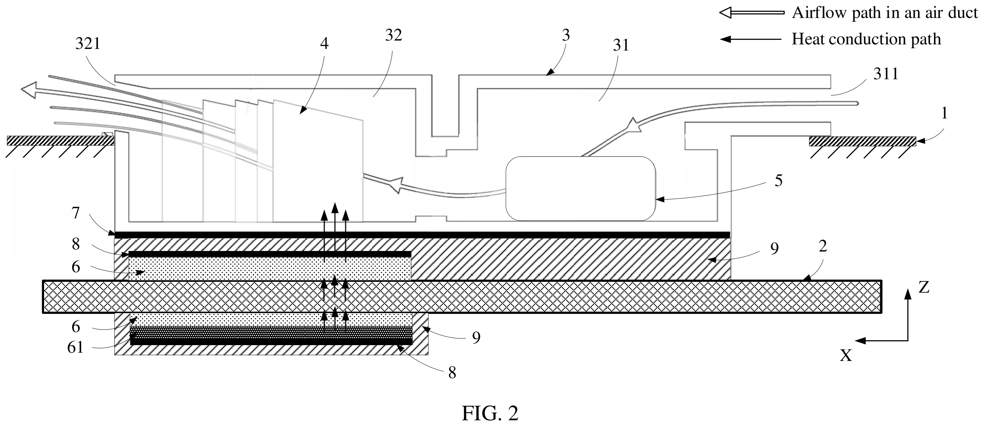

FIG. 2 is a partial sectional view of a terminal device in a side view perspective according to a first embodiment of this application. With reference to FIG. 2, the terminal device provided in this embodiment of this application includes a housing 1, a circuit board 2, a heat generation component 6, an air duct 3, a heat dissipation member 4, and a fan apparatus 5. The housing 1 may be an appearance mechanical part of the electronic device. For example, when the terminal device is a mobile phone, the housing 1 may be a rear cover or a battery cover 11 of the mobile phone, or may be a combined structure of the battery cover 11 and a camera decoration member 12. The housing 1 has large space inside, which may be used for arrangement of components such as the circuit board 2, a battery, a speaker, and a camera.

The circuit board 2 may be a printed circuit board (printed circuit board, PCB) 2, and various components may be integrated on the circuit board 2. These components may implement a plurality of functions of the terminal device. A part of the components are heat generation components 6, where the heat generation components 6 generate a large amount of heat during operation. For example, the heat generation component 6 may be a system on chip (SOC), a power management unit (Power Management Unit, PMU), or a UNIX file system (UFS). Certainly, the heat generation component 6 may alternatively be another component with high heat generation. For ease of description, in this application, an example in which the heat generation component 6 is an SOC is used for description.

The air duct 3 is a channel structure configured to guide an airflow. For example, the air duct 3 may be separately processed and manufactured, and may be installed in the housing 1 through adhesive bonding, or assembly and connection using a connection member such as a screw, thereby facilitating separate disassembly, replacement, and maintenance of the air duct 3 and a component in the air duct 3. For example, the air duct 3 may alternatively be integrally formed with the housing 1. In other words, a structure of the air duct 3 may be integrally formed during processing of the housing 1. This can improve structural strength and reliability of the air duct 3 and the housing 1, and facilitates production and manufacturing.

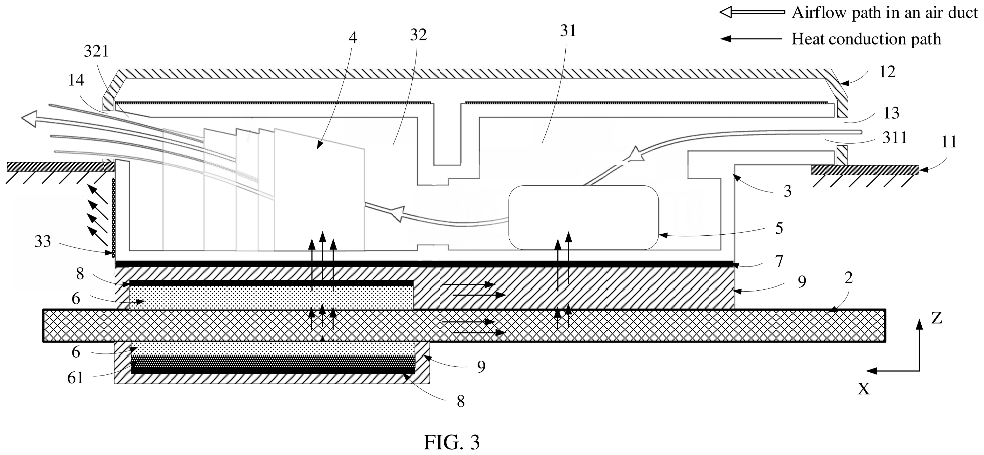

FIG. 3 is a partial sectional view of a terminal device in a side view perspective according to a second embodiment of this application. With reference to FIG. 3, the air duct 3 provided in this embodiment is disposed between the housing 1 and the circuit board 2, and the circuit board 2 and the heat generation component 6 on the circuit board 2 may conduct heat to the air duct 3. The air duct 3 includes an air inlet 311 and an air outlet 321. The housing 1 may be provided with an air inlet hole 13 and an air outlet hole 14. The air inlet 311 communicates with the air inlet hole 13 of the housing 1. The air outlet 321 communicates with the air outlet hole 14 of the housing 1. An airflow with a relatively low temperature outside the housing 1 may enter the air duct 3 sequentially from the air inlet hole 13 and the air inlet 311, and exchange heat with an airflow with a relatively high temperature in the air duct 3, so that a hot airflow can be released to an exterior of the housing 1 sequentially through the air outlet 321 and the air outlet hole 14. In an embodiment, the air duct 3 may include an air inlet duct 31 and an air outlet duct 32, the air inlet duct 31 communicates with the air outlet duct 32, the fan apparatus 5 may be disposed in the air inlet duct 31, and the heat dissipation member 4 may be disposed in the air outlet duct 32. The fan apparatus 5 in the air inlet duct 31 is close to the air inlet of the air duct 3, so that air outside the terminal device can be quickly drawn into the air duct 3 through the air inlet 311 and can be blown to the heat dissipation member 4 by the fan apparatus 5, for heat exchange with the heat dissipation member 4. The heat dissipation member 4 is disposed in the air outlet duct 32 and is close to the air outlet 321 of the air duct 3, so that high-temperature air after the heat exchange with the heat dissipation member 4 can be quickly output to an exterior of the terminal device from the air outlet 321. In this way, efficient heat dissipation can be implemented. In an embodiment, the air duct 3 may be an integrally formed structure, that is, the air inlet duct 31 and the air outlet duct 32 may be directly formed during processing and manufacture of the air duct 3. This can ensure structural reliability of the air duct 3, and facilitates assembly of the air duct 3 in the terminal device.

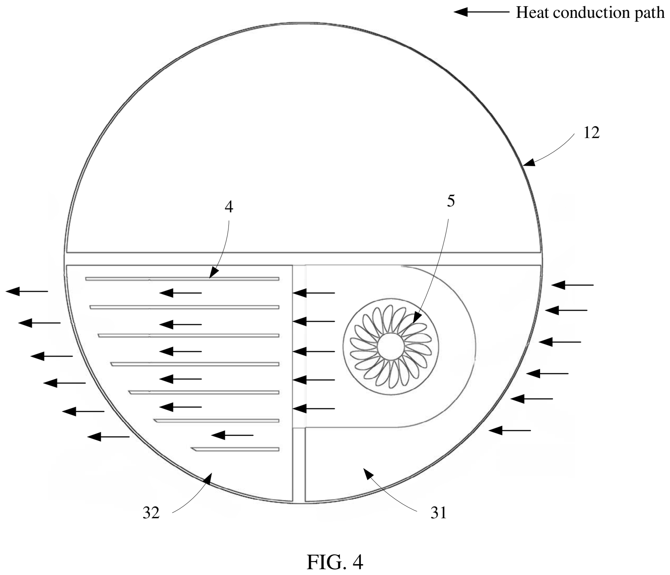

FIG. 4 is a partial sectional view in a top view perspective according to an embodiment of this application. With reference to FIG. 4, the heat dissipation member 4 has an excellent thermal conduction capability, and can provide a large area for contact with air, to implement quick and effective heat exchange. The heat dissipation member 4 may be a fin made of metal, and there may be a plurality of such fins. The plurality of fins may be spaced apart, thereby significantly expanding the area in contact with air. This can implement efficient heat exchange, and achieve quick and effective heat dissipation. In this embodiment, the heat dissipation member 4 is disposed at a position that is in the air duct 3 and that is close to the air outlet 321. Heat generated by the heat generation component 6 may be conducted to the heat dissipation member 4, and the heat dissipation member 4 may exchange heat with an airflow with a relatively low temperature in the air duct 3. Because the heat dissipation member 4 is close to the air outlet 321, the heat can be quickly dissipated to the exterior of the housing 1.

The fan apparatus 5 may be a centrifugal fan. The centrifugal fan may generate negative pressure around the centrifugal fan during operation, and the centrifugal fan is close to the air inlet. As a result, air with a relatively low temperature outside the housing 1 can be quickly guided into the air duct 3 and blown to the heat dissipation member 4, so that the air with a relatively low temperature exchanges heat with the heat dissipation member 4 with a relatively high temperature, and an airflow with a relatively high temperature after the heat exchange can be further blown to the exterior of the housing 1 from the air outlet 321 and the air outlet hole 14. In this way, efficient cooling of the heat generation component 6 can be achieved.

Therefore, according to the terminal device provided in this embodiment of this application, a heat dissipation system including the heat dissipation member 4, the fan apparatus 5, the air duct 3, and the like is disposed inside the terminal device. This can implement active heat dissipation to achieve efficient cooling of the heat generation component 6, thereby enabling the terminal device to achieve good performance during running in a high-load scenario and improving use experience of a user.

In an embodiment, with reference to FIG. 3, the air duct 3 may be provided with a thermal equalization portion 33, and the thermal equalization portion 33 is disposed on at least a part of a portion that is of the air duct 3 and that is close to the air outlet 321. The thermal equalization portion 33 has an excellent thermal conduction capability and a large heat dissipation area. After air with a low temperature input by the fan apparatus 5 exchanges heat with the heat dissipation member 4, one part of a high-temperature airflow after the heat exchange may be output to the exterior of the terminal device from the air outlet 321 and the air outlet hole 14, and the other part of the hot airflow may be in contact with the thermal equalization portion 33 for heat exchange. The thermal equalization portion 33 may diffuse heat into nearby air, and heat exchange may be further performed with air outside the terminal device through the housing 1. In this way, heat in the housing 1 is dissipated to the exterior of the terminal device. That is, after the heat generated by the heat generation component 6 is exchanged to the heat dissipation member 4, high-temperature air formed through heat exchange between low-temperature air and the heat dissipation member 4 may be diffused to the exterior of the terminal device through the air outlet 321 of the air duct 3 and the air outlet hole 14 of the housing 1, and may exchange heat with the thermal equalization portion 33, to be diffused to the exterior of the terminal device through the thermal equalization portion 33 and the nearby housing 1. In this way, the heat dissipation efficiency can be improved.

In an embodiment, the thermal equalization portion 33 may be a graphite layer. The graphite layer has an excellent thermal conduction capability, and can improve efficiency of heat exchange with a hot airflow. In addition, the graphite layer may be coated on an outer wall of the air duct 3 and a part of an inner wall that is of the air duct 3 and that is close to the air outlet 321, facilitating processing on the air duct 3. The graphite layer may be flexibly disposed based on an actual heat dissipation position. Besides, the graphite layer may be of a small thickness, which helps save space.

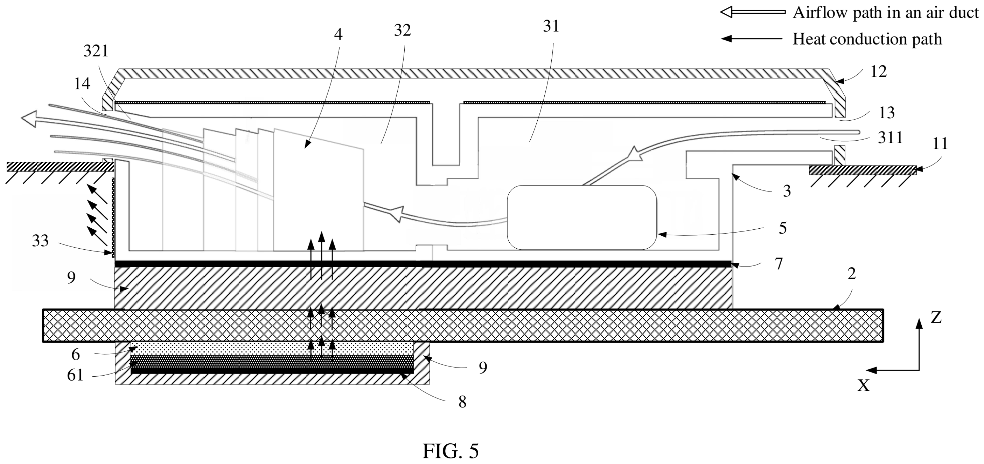

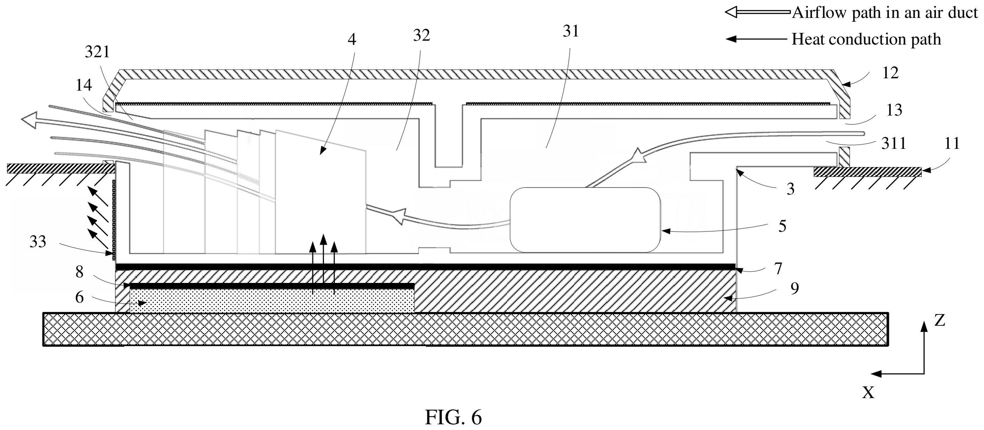

In an embodiment, FIG. 5 is a partial sectional view of a terminal device in a side view perspective according to a third embodiment of this application. With reference to FIG. 5, the heat generation component 6 may be disposed on a side that is of the circuit board 2 and that is away from the air duct 3. Heat generated by the heat generation component 6 may be conducted to the heat dissipation member 4 sequentially through the circuit board 2 and the air duct 3, and active heat dissipation may be implemented through the fan apparatus 5. The heat generation component 6 and the air duct 3 are respectively located on both sides of the circuit board 2, allowing for larger arrangement space for the air duct 3 on the circuit board 2. In addition, the foregoing active heat dissipation manner can ensure effective heat dissipation for the heat generation component 6 on the other side of the circuit board 2, eliminating a need to create a hole in a local area of the circuit board 2 or thin the local area of the circuit board 2 to reduce thermal resistance. As a result, active and efficient heat dissipation can be implemented without damaging the circuit board 2. Certainly, in some other embodiments, FIG. 6 is a partial sectional view of a terminal device in a side view perspective according to a fourth embodiment of this application. With reference to FIG. 6, the heat generation component 6 may alternatively be disposed on a side that is of the circuit board 2 and that faces the air duct 3. Heat generated by the heat generation component 6 may be conducted to the heat dissipation member 4 through a wall plate of the air duct 3 without passing through the circuit board 2. In some other embodiments, with reference to FIG. 2, heat generation components 6 may alternatively be disposed on both sides of the circuit board 2. This is not limited in this embodiment.

In an embodiment, for some terminal devices such as a mobile phone and a tablet computer, the housing 1 of the terminal device may include a battery cover 11 and a camera decoration member 12. The battery cover 11 is an appearance member on a back of the terminal device, and may be directly touched by a user. The camera decoration member 12 may cover an exterior of a camera module as an appearance member of the camera module, thereby protecting the camera module. The camera decoration member 12 may be connected to the battery cover 11 through adhesive bonding, a screw, or the like. The camera decoration member 12 protrudes from an outer wall of the battery cover 11, and has accommodation space inside, where the accommodation space may be configured to accommodate the camera module, and at least a part of the air duct 3 may also be disposed in the accommodation space inside the camera decoration member 12. The camera decoration member 12 protrudes from a surface of the battery cover 11. At least a part of the air duct 3 may be disposed between the battery cover 11 and the circuit board 2, and at least a part of the air duct 3 may be accommodated in the accommodation space inside the camera decoration member 12, thereby eliminating a need for the air duct 3 to occupy additional Z-direction space of the entire terminal device. This facilitates a thinning design of the terminal device. The Z direction is a thickness direction of the terminal device.

In an embodiment, in a first direction X, the camera decoration member 12 has a side wall; the side wall is provided with the air inlet hole 13 and the air outlet hole 14; and the first direction X is perpendicular to the thickness direction Z of the terminal device. The camera decoration member 12 has the side wall, and is made to protrude from the outer wall of the battery cover 11, thereby forming the accommodation space inside the camera decoration member 12. The air inlet hole 13 and the air outlet hole 14 may be provided at appropriate positions on the side wall, and the air inlet 311 and the air outlet 321 may be provided at positions on a part that is of the air duct 3 and that is in the camera decoration member 12, so that the air inlet 311 and the air outlet 321 are close to, or are aligned with and communicate with the air inlet hole 13 and the air outlet hole 14 on the camera decoration member 12 respectively. This can ensure air intake and air exhaust efficiency, thereby helping improve the heat dissipation efficiency.

In an embodiment, with reference to FIG. 3, in the thickness direction Z of the terminal device, at least a part of a projection of the heat generation component 6 coincides with a projection of the heat dissipation member 4. The heat dissipation member 4 is a main heat exchange part. Making at least the part of the projection of the heat generation component 6 in the thickness direction Z of the terminal device coincide with the projection of the heat dissipation member 4 can shorten a heat dissipation path between the heat generation component 6 and the heat dissipation member 4. As a result, most heat of the heat generation component 6 can be quickly conducted to the heat dissipation member 4, and heat exchange can be performed through the heat dissipation member 4, thereby implementing quick and efficient cooling.

In an embodiment, with reference to FIG. 3, the terminal device further includes a first thermally conductive medium 7 made of a flexible material, the first thermally conductive medium 7 is disposed between the circuit board 2 and the air duct 3, and heat of the heat generation component 6 is conducted to the heat dissipation member 4 sequentially through the first thermally conductive medium 7 and a side wall of the air duct 3. Both the circuit board 2 and the air duct 3 are made of hard materials. Therefore, when the circuit board 2 and the air duct 3 are directly connected to each other, it is difficult to ensure a tight connection between the circuit board 2 and the air duct 3, and a gap is likely to form between the circuit board 2 and the air duct 3. Consequently, heat cannot be effectively conducted to the heat dissipation member 4 in the air duct 3. To address this, in this embodiment, the first thermally conductive medium 7 made of the flexible material is used, and the first thermally conductive medium 7 may be fully filled between the circuit board 2 and the air duct 3 through flexible deformation of the first thermally conductive medium 7. This can ensure that there is no gap in a heat conduction path between the circuit board 2 and the air duct 3, thereby improving heat conduction efficiency and improving the heat dissipation efficiency.

In an embodiment, the first thermally conductive medium 7 may be made of thermally conductive gel or thermal grease. Due to excellent thermal conduction capabilities and specific degrees of flexibility, these materials can be fully filled between the circuit board 2 and the air duct 3, thereby eliminating a gap in the heat conduction path and improving the heat dissipation efficiency.

There are many components on the circuit board 2, and the components are densely integrated on the circuit board 2. A small distance between some components is likely to cause electromagnetic interference, affecting normal operation of the some components. Therefore, with reference to FIG. 3, in an embodiment, the terminal device provided in this embodiment further includes an electromagnetic shielding member 9, and the electromagnetic shielding member 9 may cover the heat generation component 6. In an embodiment, the heat generation component 6 is disposed on a surface that is of the circuit board 2 and that faces the air duct 3, the electromagnetic shielding member 9 is disposed between the first thermally conductive medium 7 and the circuit board 2, the electromagnetic shielding member 9 is provided with an accommodation groove, and the accommodation groove is configured to accommodate some components on the circuit board 2. These components may be heat generation components 6 or non-heat-generation components. For the heat generation component, at least a part of heat of the heat generation component 6 is conducted to the heat dissipation member 4 sequentially through the electromagnetic shielding member 9, the first thermally conductive medium 7, and the wall plate of the air duct 3. The electromagnetic shielding member 9 may be a member made of metal, such as copper or aluminum, and has an electromagnetic shielding function. A component that generates electromagnetic interference or a component that is affected by electromagnetic interference may be covered in the accommodation groove, to isolate the electromagnetic interference through the accommodation groove. In addition, because the electromagnetic shielding member 9 is a member made of metal, that is, both the electromagnetic shielding member 9 and the air duct 3 are rigid members, if the electromagnetic shielding member 9 and the air duct 3 are directly connected to each other, a gap is likely to form between the electromagnetic shielding member 9 and the air duct 3. Due to the gap, heat cannot be effectively conducted to the heat dissipation member 4, which reduces the heat dissipation efficiency. To address this, in this embodiment, the first thermally conductive medium 7 may be filled between the electromagnetic shielding member 9 and the air duct 3. The first thermally conductive medium 7 may be fully filled between the electromagnetic shielding member 9 and the air duct 3 by using flexibility of the first thermally conductive medium 7, to eliminate a gap. In addition, the electromagnetic shielding member 9 made of metal exhibits an excellent thermal conduction property, so that heat generated by the heat generation component 6 can be efficiently conducted to the heat dissipation member 4 sequentially through the electromagnetic shielding member 9, the first thermally conductive medium 7, and the side wall of the air duct 3. The side wall of the air duct 3 is a side wall configured to connect to the heat dissipation member 4. In an embodiment, the electromagnetic shielding member 9 may be assembled onto the circuit board 2 by using a surface mount technology (Surface Mount Technology, SMT), thereby improving assembly reliability, reducing a solder joint defect rate, and helping improve integration.

In an embodiment, with reference to FIG. 3, the electromagnetic shielding member 9 may be an integrally formed structure, and the accommodation groove can be directly formed during formation of the electromagnetic shielding member 9. This facilitates processing and manufacture, and can ensure overall structural reliability of the electromagnetic shielding member 9. The accommodation groove may be a groove structure that is through on one side of the electromagnetic shielding member 9 and is not through on the other side of the electromagnetic shielding member 9 in the thickness direction Z. After the electromagnetic shielding member 9 is assembled onto the circuit board 2, an opening side of the accommodation groove may be sealed by the circuit board 2, to form closed space, thereby improving electromagnetic shielding effect. In addition, the component accommodated in the accommodation groove may alternatively be the heat generation component 6. To improve heat conduction efficiency of the heat generation component 6 in the accommodation groove, a second thermally conductive medium 8 made of a flexible material may also be filled in the accommodation groove. The second thermally conductive medium 8 may be fully filled between the heat generation component 6 and an inner wall of the accommodation groove by using flexibility of the second thermally conductive medium 8, to eliminate a gap. As a result, heat generated by the heat generation component 6 in the accommodation groove can be conducted to the heat dissipation member 4 sequentially through the second thermally conductive medium 8, the electromagnetic shielding member 9, the first thermally conductive medium 7, and a wall plate of the air duct 3. In an embodiment, the second thermally conductive medium 8 may be made of thermally conductive gel or thermal grease. Due to excellent thermal conduction capabilities and specific degrees of flexibility, these materials can be fully filled between the circuit board 2 and the air duct 3, thereby eliminating a gap in the heat conduction path and improving the heat dissipation efficiency. It may be understood that the first thermally conductive medium 7 and the second thermally conductive medium 8 may be made of a same material or different materials. This is not limited in this application.

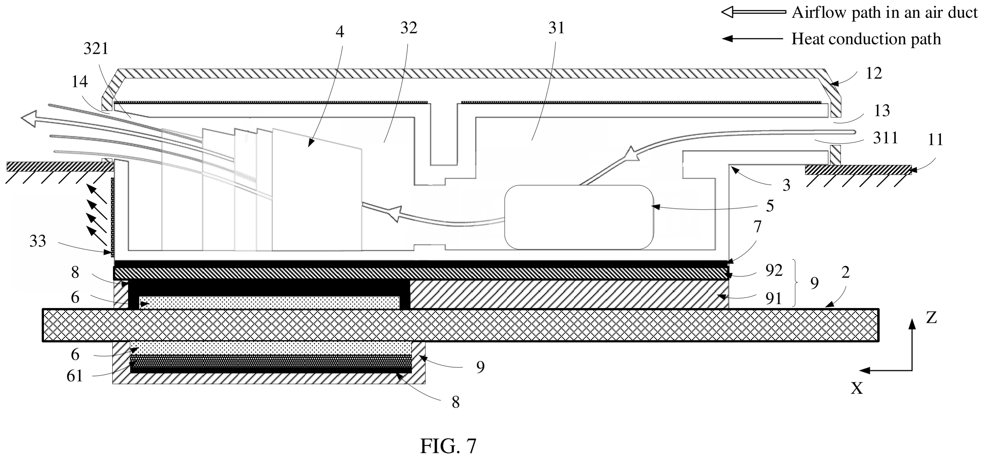

In an embodiment, FIG. 7 is a partial sectional view of a terminal device in a side view perspective according to a fifth embodiment of this application. With reference to FIG. 7, the electromagnetic shielding member 9 includes a body 91 and a cover plate 92, the body 91 is disposed on the circuit board 2, the accommodation groove is a through groove, and the through groove runs through the body 91 in the thickness direction Z of the terminal device. The cover plate 92 is fitted to a side that is of the body 91 and that is away from the circuit board 2, to seal the through groove, and the cover plate 92 is connected to the air duct 3 through the first thermally conductive medium 7. The electromagnetic shielding member 9 is a structure assembled from the body 91 and the cover plate 92 as separate parts. That is, after the body 91 is mounted onto the circuit board 2 through an SMT process, the cover plate 92 may be fitted and fastened to the body 91 through soldering, adhesive bonding, or the like, to seal the through groove and achieve effective electromagnetic shielding. After the body 91 is mounted onto the circuit board 2, the second thermally conductive medium 8 such as the thermally conductive gel or the thermal grease may be injected into the through groove, to implement heat conduction for a component in the through groove. In this embodiment, the cover plate 92 may be fitted to the body 91 to seal the through groove. This facilitates injection of thermally conductive gel with a higher thermal conductivity into the through groove, to improve a thermal conduction capability and consequently improve heat dissipation efficiency of the heat generation component 6.

In an embodiment, with reference to FIG. 5, the heat generation component 6 may alternatively be disposed on the side that is of the circuit board 2 and that is away from the air duct 3. For example, the heat generation component 6 may be a system on chip. To reduce electromagnetic interference between the heat generation component 6 on the side that is of the circuit board 2 and that is away from the air duct 3 and a surrounding component, the heat generation component 6 may use the foregoing electromagnetic shielding member 9 to perform electromagnetic shielding. A structure, effect, and the like of the electromagnetic shielding member 9 are the same as those of the foregoing electromagnetic shielding member, and details are not described herein again. A second thermally conductive medium 8 may also be filled between the heat generation component 6 on the side that is of the circuit board 2 and that is away from the air duct 3 and the electromagnetic shielding member 9. The second thermally conductive medium 8 has a same function as the foregoing second thermally conductive medium, and details are not described herein again. In an embodiment, the heat generation component 6 on the side that is of the circuit board 2 and that is away from the air duct 3 may be a system on chip, and a side that is of the system on chip and that is away from the circuit board 2 may be connected to a double data rate synchronous dynamic random access memory (Double Data Rate SDRAM, DDR SDRAM) 61. The DDR SDRAM has a data transmission speed that is twice a system clock frequency, exhibiting excellent transmission performance. The system on chip and the DDR SDRAM may be covered in the electromagnetic shielding member 9 as a whole (with reference to FIG. 5).

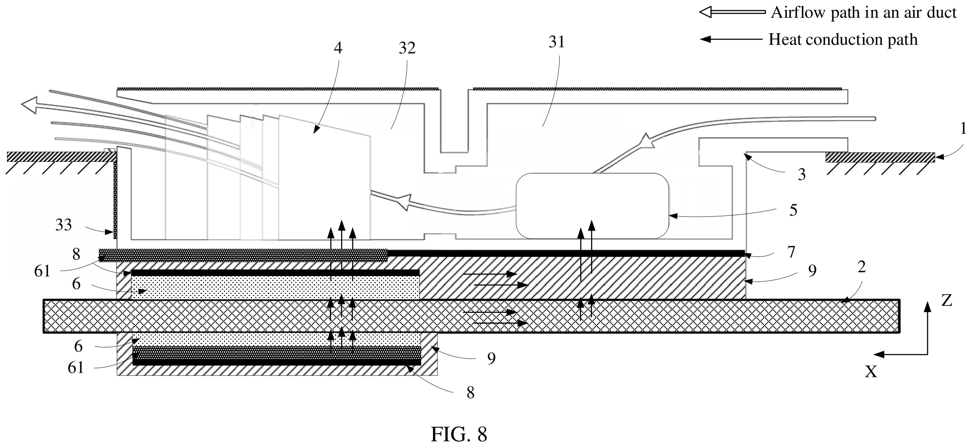

As described above, the heat dissipation member 4 is a main heat dissipation part. Making projections of the heat generation component 6, the first thermally conductive medium 7, and the electromagnetic shielding member 9 coincide with the projection of the heat dissipation member 4 in the thickness direction Z of the terminal device can shorten a heat dissipation path, thereby implementing quick and effective heat dissipation. FIG. 8 is a partial sectional view of a terminal device in a side view perspective according to a sixth embodiment of this application. With reference to FIG. 8, to further improve the heat dissipation efficiency, in an embodiment, in the thickness direction Z of the terminal device, at least a part of projections of the first thermally conductive medium 7 and the electromagnetic shielding member 9 coincides with projections of the heat dissipation member 4 and the fan apparatus 5. In other words, the projections of the first thermally conductive medium 7 and the electromagnetic shielding member 9 in the thickness direction Z of the terminal device may cover both the heat dissipation member 4 and the fan apparatus 5. As a result, most heat generated by the heat generation component 6 can be conducted to the relatively closer heat dissipation member 4 sequentially through the electromagnetic shielding member 9 and the first thermally conductive medium 7. In addition, at least a part of heat generated by the heat generation component 6 can be conducted to the relatively farther fan apparatus 5 through the electromagnetic shielding member 9 and the first thermally conductive medium 7, so that the heat can be conducted to a structure such as a blade of the fan apparatus 5 and heat exchange can be performed with air through the fan apparatus 5. This can further expand, through the fan apparatus 5, a heat dissipation area in contact with the air, thereby improving the heat dissipation efficiency.

The foregoing descriptions are merely preferred embodiments of this application, and are not intended to limit this application. For a person skilled in the art, this application may have various modifications and variations. Any modification, equivalent replacement, improvement, and the like made without departing from the spirit and principle of this application shall fall within the protection scope of this application.

## Claims

1. A terminal device, comprising:
a housing, wherein the housing is provided with an air inlet hole and an air outlet hole;
a circuit board, disposed in the housing;
a heat generation component, disposed on the circuit board;
an air duct, disposed between the housing and the circuit board, wherein the air duct comprises an air inlet and an air outlet, the air inlet communicates with the air inlet hole, and the air outlet communicates with the air outlet hole;
a heat dissipation member, disposed at a position that is in the air duct and that is close to the air outlet; and
a fan apparatus, disposed at a position that is in the air duct and that is close to the air inlet.

2. The terminal device according to claim 1, wherein in a thickness direction of the terminal device, at least a part of a projection of the heat generation component coincides with a projection of the heat dissipation member.

3. The terminal device according to claim 1, further comprising a first thermally conductive medium, wherein the first thermally conductive medium is disposed between the circuit board and the air duct.

4. The terminal device according to claim 3, wherein the first thermally conductive medium is made of thermally conductive gel or thermal grease.

5. The terminal device according to claim 3 or 4, further comprising an electromagnetic shielding member, wherein the electromagnetic shielding member is provided with an accommodation groove, and the accommodation groove is configured to accommodate a component on the circuit board.

6. The terminal device according to claim 5, wherein the electromagnetic shielding member is disposed between the first thermally conductive medium and the circuit board, and/or the electromagnetic shielding member is disposed on a side that is of the circuit board and that is away from the air duct.

7. The terminal device according to claim 5 or 6, wherein the electromagnetic shielding member comprises a body and a cover plate, the body is disposed on the circuit board, the accommodation groove is a through groove, and the through groove runs through the body in a thickness direction of the terminal device; and
the cover plate is fitted to a side that is of the body and that is away from the circuit board, to seal the through groove, and the cover plate is connected to the air duct through the first thermally conductive medium.

8. The terminal device according to any one of claims 5 to 7, wherein the electromagnetic shielding member is made of thermally conductive metal.

9. The terminal device according to any one of claims 5 to 8, further comprising a second thermally conductive medium, wherein the second thermally conductive medium is filled between the component in the accommodation groove and an inner wall of the accommodation groove.

10. The terminal device according to claim 9, wherein the second thermally conductive medium is made of thermally conductive gel or thermal grease.

11. The terminal device according to any one of claims 3 to 10, wherein in the thickness direction of the terminal device, at least a part of projections of the first thermally conductive medium and the electromagnetic shielding member coincides with projections of the heat dissipation member and the fan apparatus.

12. The terminal device according to any one of claims 1 to 11, wherein the air duct comprises an air inlet duct and an air outlet duct, the air inlet duct communicates with the air outlet duct, the fan apparatus is disposed in the air inlet duct, and the heat dissipation member is disposed in the air outlet duct.

13. The terminal device according to any one of claims 1 to 12, wherein the air duct is provided with a thermal equalization portion, and the thermal equalization portion is disposed on at least a part of a portion that is of the air duct and that is close to the air outlet.

14. The terminal device according to claim 13, wherein the thermal equalization portion is a graphite layer.

15. The terminal device according to claims 1 to 14, wherein the air duct is connected to the housing through adhesive bonding, or the air duct is connected to the housing through a connection member, or the air duct is integrally formed with the housing.

16. The terminal device according to any one of claims 1 to 15, wherein the heat generation component is disposed on the side that is of the circuit board and that is away from the air duct.

17. The terminal device according to any one of claims 1 to 16, wherein the heat dissipation member comprises a plurality of metal fins.

18. The terminal device according to any one of claims 1 to 17, wherein the housing comprises a battery cover and a camera decoration member, the camera decoration member is disposed on the battery cover, the camera decoration member protrudes from an outer wall of the battery cover, the camera decoration member has accommodation space inside, and at least a part of the air duct is disposed in the accommodation space.

19. The terminal device according to claim 18, wherein in a first direction, the camera decoration member has a side wall; the side wall is provided with the air inlet hole and the air outlet hole; and the first direction is perpendicular to the thickness direction of the terminal device.

20. The terminal device according to any one of claims 1 to 19, wherein the heat generation component is a system on chip, a power management unit, or a UNIX file system.
